(19) Europäisches Patentamt
European Patent Office
Office européen des brevets

(11) **EP 3 354 771 A1**

(12) **EUROPEAN PATENT APPLICATION**
published in accordance with Art. 153(4) EPC

(43) Date of publication:
**01.08.2018 Bulletin 2018/31**

(21) Application number: **15904804.0**

(22) Date of filing: **23.12.2015**

(51) Int Cl.:
*C23C 28/00* (2006.01)　　　*C23C 16/06* (2006.01)
*C23C 16/22* (2006.01)　　　*C23C 16/455* (2006.01)
*C23C 16/40* (2006.01)　　　*C23C 14/08* (2006.01)
*C23C 14/14* (2006.01)　　　*C23C 14/16* (2006.01)

(86) International application number:
**PCT/KR2015/014157**

(87) International publication number:
**WO 2017/051993 (30.03.2017 Gazette 2017/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **21.09.2015 KR 20150132795
08.12.2015 KR 20150173836**

(71) Applicant: **Posco
Pohang-si, Gyeongsangbuk-do 37859 (KR)**

(72) Inventors:
• **JEONG, Hyunju**
  **Hwaseong-si**
  **Gyeonggi-do 18303 (KR)**
• **LEE, Jong-Seog**
  **Incheon 21986 (KR)**
• **LEE, Jeong-Hee**
  **Incheon 22009 (KR)**

(74) Representative: **Zech, Stefan Markus
Meissner Bolte Patentanwälte
Rechtsanwälte Partnerschaft mbB
Postfach 86 06 24
81633 München (DE)**

(54) **COLOR-TREATED SUBSTRATE AND COLOR TREATMENT METHOD THEREFOR**

(57)　The present invention relates to a colored substrate containing magnesium and a substrate coloring method therefor. The colored substrate according to the present invention has a structure in which a film containing a metal oxide and a wavelength conversion layer are sequentially laminated on a magnesium base, and can thus uniformly display various colors on the surface thereof through the control of the average thickness of the film while maintaining the unique texture and gloss of the metal.

[FIG. 2]

EP 3 354 771 A1

**Description**

[TECHNICAL FIELD]

The present invention relates to a colored magnesium-containing substrate and a substrate coloring method therefor.

[BACKGROUND ART]

Among metals of practical use, magnesium is a metal which belongs to ultra light metals, has excellent abrasion resistance, and is highly resistant to sunlight and is eco-friendly, but has difficulty in realizing a metal texture and various colors. Further, magnesium is very difficult to industrially apply because it has the lowest electrochemical performance and is quickly corroded in air or in a solution.

Recently, due to the weight reduction trend in the overall industry, the magnesium industry has been receiving attention. As exterior materials with a metal texture have become popular in the field of electrical and electronic component materials such as mobile phone case parts, research to resolve the above-described problem of magnesium is actively underway.

As a result, Korean Patent Publication No. 2011-0016750 disclosed a PVD-sol gel method of performing dry coating and then sol-gel coating on a metal-containing material in order to realize a metal texture and ensure corrosion resistance of a surface of a base formed of a magnesium alloy, and U.S. Patent Publication No. 2011-0303545 disclosed an anodizing method of performing chemical polishing on a surface of a magnesium-containing base to gloss the surface and anodizing the base in a basic electrolyte having dye or pigment dissolved therein to give color to the surface.

However, the PVD-sol gel method has a problem in that even though a metal texture is realized, the texture is not a metal texture unique to magnesium, and the realization of a variety of colors is difficult. Furthermore, when coloring is performed using an anodizing method as described above, an opaque oxide film is formed on the surface of the base, making it difficult to realize a unique metal texture.

Accordingly, in order to commercialize a magnesium-containing base, there is an urgent need for a technique capable of chemically, electrochemically, or physically treating the surface of the base to realize a desired color without the use of dyes and realize the intrinsic texture of metals.

[DETAILED DESCRIPTION OF THE INVENTION]

[TECHNICAL PROBLEM]

In order to solve the above problems, the present invention is directed to providing a colored substrate containing magnesium capable of uniformly realizing various colors while maintaining a metal texture and gloss.

The present invention is also directed to providing a substrate coloring method.

[TECHNICAL SOLUTION]

In order to achieve the above objects, according to an embodiment of the present invention, there is provided a colored substrate including a magnesium base; a film provided on the magnesium base and containing a metal oxide; and a wavelength conversion layer provided on the film.

Also, according to an embodiment of the present invention, there is provided a substrate coloring method including: forming a film on a magnesium base; and forming a wavelength conversion layer on the film, wherein the film contains a metal oxide.

[ADVANTAGEOUS EFFECTS OF THE INVENTION]

The colored substrate according to the present invention has a structure in which a film containing a metal oxide and a wavelength conversion layer are sequentially stacked on a magnesium base, and can thus uniformly display various colors on a surface thereof through the control of an average thickness of the film while maintaining a unique metal texture and gloss.

[DESCRIPTION OF THE DRAWINGS]

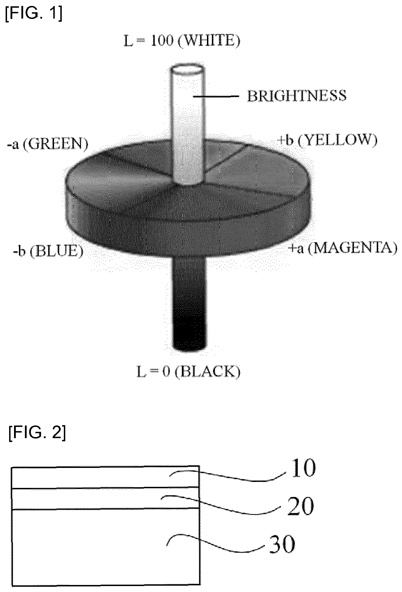

FIG. 1 shows an image including a CIE color space.

FIG. 2 is a sectional view showing a structure of a substrate wherein one surface of a base has been colored according to the present invention, wherein a reference numeral 10 indicates a wavelength conversion layer, a reference numeral 20 is a film, and a reference numeral 30 is a magnesium base.

FIG. 3 shows an image including a surface and a section of a magnesium base on which a film with an average thickness of 2 μm is formed after scratching with a load of 50 N during evaluation of abrasion resistance.

FIG. 4 shows an image including a surface and a section of a magnesium base on which a film with an average thickness of 5 μm is formed after scratching with a load of 50 N during evaluation of abrasion resistance.

FIG. 5 shows an image including a surface and a section of a magnesium base on which no film is formed after scratching with a load of 5 N during evaluation of abrasion resistance.

FIG. 6 shows an image obtained by capturing a surface of a colored substrate 72 hours after spraying saline water on the surface according to another embodiment.

FIG. 7 shows an image obtained by performing a cross-cut tape test, after immersion in hot water at 95°C, on a colored substrate according to still another embodiment.

FIG. 8 shows an image obtained by capturing a surface of a colored substrate after evaluating moisture resistance under constant temperature and humidity conditions of 50°C and 95%.

FIGS. 9 to 11 are graphs showing, when evaluating abrasion resistance, an average depth D of a scratch on a colored substrate according to an embodiment.

[BEST MODE]

While the invention is susceptible to various modifications and alternative forms, specific embodiments thereof are shown by way of example in the drawings and will herein be described in detail.

It should be understood, however, that there is no intent to limit the invention to the particular forms disclosed, but on the contrary, the invention is to cover all modifications, equivalents, and alternatives falling within the spirit and scope of the invention.

It will be further understood that the terms "comprises," "comprising," "includes," and/or "including" when used herein, specify the presence of stated features, integers, steps, operations, elements, and/or components, but do not preclude the presence or addition of one or more other features, integers, steps, operations, elements, components, and/or a combination thereof.

Further, in the drawings of the present invention, the size and relative sizes of layers, regions and/or other elements may be exaggerated or reduced for clarity.

Hereinafter, example embodiments of the present invention will be described in detail with reference to the accompanying drawings. In the figures, the same reference numerals are used to denote the same elements throughout the drawings and redundant descriptions thereof will be omitted.

The term "color coordinates" used herein refers to coordinates in a CIE Lab color space, which are color values defined by the International Commission on Illumination (abbreviated CIE for its French name, Commission internationale de l'eclairage), and any position in the CIE color space may be expressed by three coordinate values L*, a*, and b*.

Here, the value L* indicates brightness, L*=0 indicates a black color, and L*=100 indicates a white color. Moreover, the value a* represents whether a color with corresponding color coordinates is closer to a pure magenta color or a pure green color, and the value b* represents whether a color with corresponding color coordinates is closer to a pure yellow color or a pure blue color.

Specifically, the value a* ranges from -a to +a, the maximum of the value a* (a* max) represents a pure magenta color, and the minimum of the value a* (a* min) represents a pure green color. For example, when the value a* is negative, the color is closer to a pure green color, and when the value a* is positive, the color is closer a pure magenta color. When a*=80 and a*=50 are compared to each other, a*=80 is closer to a pure magenta color than a*=50. Furthermore, the value b* ranges from -b to +b. The maximum of the value b* (b* max) represents a pure yellow color, and the minimum of the value b* (b* min) represents a pure blue color. For example, when the value b* is negative, the color is closer to a pure yellow color, and when the value b* is positive, the color is closer to a pure blue color. When b*=50 and b*=20 are compared to each other, b*=80 is closer to a pure yellow color than b*=50.

Further, the term "color deviation" or "color coordinate deviation" used herein refers to a distance between two colors in the CIE Lab color space. That is, a longer distance denotes a larger difference in color, and a shorter distance denotes a smaller difference in color, and this may be expressed by ΔE* represented by the following Equation 1:

[Equation 1]

$$\Delta E^* = \sqrt{(\Delta L^*)^2 + (\Delta a^*)^2 + (\Delta b^*)^2}.$$

Further, a unit "T" used herein represents a thickness of a magnesium-containing base, and may be the same as a unit "mm."

Also, a unit "N" used herein represents a unit indicating the magnitude of force, and 1N denotes a force corresponding to the gravity (weight) acting on an object having a mass of about 0.1 kg (1 kgf≒9.8N).

Furthermore, the term "abrasion" used herein refers to a characteristic of a magnesium substrate becoming worn down when pressed with a material formed of another substance. The abrasion may be affected by the hardness, elastic modulus, yield stress, etc., of the magnesium substrate.

In addition, the term "magnesium base" used herein refers to a mother base containing magnesium before the surface is processed. The magnesium substrate is obtained by surface-treating a mother base containing magnesium.

The present invention relates to a colored magnesium-containing substrate and a substrate coloring method therefor.

Conventionally, a PVD-sol gel method, an anodizing method, or the like, which is a method of coating a surface of a material with a metal-containing material, a pigment, or the like, has been known as a method for realizing a color on a magnesium-containing material. However, these methods may cause a reduction in durability of the base. Further, it is difficult to realize a uniform color on the surface of the material, and, because a coated film layer becomes easily detached, there is a problem of not achieving sufficient reliability. Particularly, the methods do not realize a unique metal texture, and thus it is difficult to utilize the methods in the fields of building exteriors, automobile interiors, and particularly electrical and electronic component materials such as mobile product frames.

In order to overcome these problems, the present invention provides a colored magnesium-containing substrate and a substrate coloring method therefor.

A colored substrate according to the present invention has a structure in which a film containing a metal oxide and a wavelength conversion layer are sequentially stacked on a magnesium base, and can thus uniformly realize various colors on a surface thereof through the control of an average thickness of the film while maintaining a unique metal texture and glossiness. Accordingly, the colored structure may be usefully utilized in the fields of building exteriors for which a metal material is used, automobile interiors, and particularly electrical and electronic component materials such as mobile product frames.

The present invention will be described below in detail.

The present invention provides a colored substrate including a magnesium base; a film provided on the base and containing a metal oxide; and a wavelength conversion layer provided on the film.

The colored substrate according to the present invention may have a structure in which a film containing a metal oxide and a wavelength conversion layer are sequentially stacked on a magnesium base. The stacked structure may be one or both sides of the magnesium base.

When a single film containing a metal oxide according to the present invention is formed on a base, it is possible to realize a color. However, when a single film is formed on a magnesium base, it is difficult to realize a color. Accordingly, conventionally, a coloring layer was formed by using a coating agent obtained by mixing a metal oxide with pigment in order to color a surface of the magnesium base. However, by uniformly stacking a wavelength conversion layer on a magnesium base along with a film containing a metal oxide, the colored substrate of the present invention may induce optical interference in light incident on a surface of the substrate and uniformly realize a color on the surface.

As an example, the colored substrate according to the present invention satisfies one or more conditions among $\Delta L^* < 0.5$, $\Delta a^* < 0.6$, and $\Delta b^* < 0.6$, which are average color coordinate deviations $\Delta L^*$, $\Delta a^*$, and $\Delta b^*$ obtained by measuring CIE color coordinates of any three points included in any region (having a width of 1 cm and a length of 1 cm) present on the wavelength conversion layer. In detail, the colored substrate according to the present invention may satisfy two or more of the conditions. More specifically, all of the conditions may be satisfied.

In an embodiment of the present invention, CIE color coordinates of any three points included in any region present on a colored substrate were measured. The result was that the color coordinate deviations were $05 < \Delta L^* < 0.25$, $0.01 < \Delta a^* < 0.3$, and $0.2 < \Delta b^* < 0.5$. Also, the colored substrate exhibited a color coordinate deviation of $0.15 < \Delta E^* \leq 0.55$, and a deviation between realized colors was small.

From the result, it can be seen that the colored substrate according to the present invention may uniformly realize a color on a surface thereof by forming a structure in which a film containing a metal oxide and a wavelength conversion layer are sequentially stacked on a magnesium base, which is not colored by just the film containing a metal oxide.

Elements of the colored substrate according to the present invention will be described in detail below.

First, the magnesium base serves to determine a default frame and a material property of a substrate and may indicate a substrate that is not yet colored.

In this case, the type or form of the magnesium base is not particularly limited as long as it can be used as a frame in the field of electrical and electronic product materials. Examples of the matrix include a magnesium base made of magnesium; a magnesium alloy to which aluminum, manganese, or the like has been added; and a stainless steel or titanium (Ti) base in which magnesium has been dispersed on a surface thereof may be used.

Subsequently, the film may serve to realize various colors, depending on its average thickness, by changing properties of light incident on the magnesium base. Also, the film may function to improve reliability characteristics such as abrasion resistance, corrosion resistance, or moisture resistance of the magnesium base before the wavelength conversion layer is formed.

As another example, the condition of the following Equation 1 may be satisfied when abrasion resistance evaluation is performed on a surface of a magnesium base on which a film is formed.

$$[\text{Equation 1}]$$

$$0.3 \ \leq \ 400/\pi \cdot W^2 \ \leq \ 20$$

where W is an average width of a scratch generated on a surface of the film when the surface is scratched once with a ball having an average diameter of 6 mm under a load of 50 N and at a rate of 3 cm/s, and has a unit of GPa.

In detail, ranges of 0.3 GPa to 19 GPa, 0.34 GPa to 15 GPa, 0.38 GPa to 10 GPa, 0.4 GPa to 5 GPa, 0.3 GPa to 1 GPa, 0.3 GPa to 0.6 GPa, 1 GPa to 5 GPa, 5 GPa to 10 GPa, 10 GPa to 15 GPa, 15 GPa to 20 GPa, or 12 GPa to 13 GPa may allow the magnesium base to satisfy the condition of Equation 1.

In the present invention, abrasion resistance of a surface-treated substrate and a surface-untreated surface on which a film was formed on a magnesium base was evaluated by using a tribometer. As a result, a scratch was not generated on the surface-treated substrate including the film under a low load of 5 N. Also, a scratch was generated on the surface-treated substrate including the film due to the surface of the film being pressed under a high load of 50 N , but the scratch was insignificant. Accordingly, the magnesium base was not exposed, and the condition of Equation 1 indicated a value ranging from 0.3 GPa to 0.6 GPa. Here, Equation 1, which is an equation associated with a vertical load per unit area acting on a ball while a scratch is generated, indicates a correlation between the width of the scratch and the elastic restoring force of the film according to the load of the ball. The result indicates that a magnesium material, which is a mother base, can be protected by the film formed on the magnesium base buffering against abrasion generated on the surface.

In this case, the film is not particularly limited as long as the film is a transparent film capable of transmitting light and contains a metal oxide. For example, the film may include one kind of metal oxide selected from the group consisting of a silicon oxide ($SiO_2$), a titanium oxide ($TiO_2$), and an aluminum oxide ($Al_2O_3$).

Also, when the film has a specific thickness, the film can induce optical interference in incident light along with the wavelength conversion layer formed on the film to realize a color. Here, the average thickness of the film may range from 1 nm to 6 nm, specifically, from 1 nm to 2 $\mu$m; from 10 nm to 1 $\mu$m; from 20 nm to 1.5 $\mu$m; from 10 nm to 500 nm; from 500 nm to 2 $\mu$m; from 3 $\mu$m to 5 $\mu$m; from 4 $\mu$m to 6 $\mu$m ; from 10 nm to 200 nm; from 100 nm to 1 $\mu$m ; or from 1 $\mu$m to 6 $\mu$m. According to the present invention, by adjusting the average thickness of the film, it is possible to uniformly realize a color on a surface while preventing discoloration of the magnesium base.

Subsequently, the wavelength conversion layer is formed on the film and configured to induce optical interference along with the film, thus serving to exhibit a color of a metal texture on a surface thereof.

In this case, the wavelength conversion layer is not particularly limited as long as it has a refractive index different from that of the film and can realize a metal texture. As an example, the wavelength conversion layer may contain one or more kinds of metals or ions from the group consisting of aluminum (Al), chromium (Cr), titanium (Ti), gold (Au), molybdenum (Mo), silver (Ag), manganese (Mn), zirconium (Zr), palladium (Pd), platinum (Pt), cobalt (Co), cadmium (Cd), nickel (Ni), and copper (Cu) and may specifically include a chromium (Cr) metal, aluminum (Al) metal, chromium (Cr) ions, or aluminum (Al) ions.

Also, the metal may include various forms such as a metal particle, a metal oxide, or the like, and the wavelength conversion layer may be a continuous layer in which such metals are tightly stacked close together on the film to completely cover the surface or a discontinuous layer in which metals are dispersed on the film, but is not limited thereto.

Further, the wavelength conversion layer may have an average thickness ranging from 5 nm to 200 nm. Preferably, the wavelength conversion layer may have an average thickness ranging from 5 nm to 150 nm; from 10 nm to 100 nm; or from 10 nm to 60 nm. According to the present invention, it is possible to reduce light transmission of the wavelength conversion layer and to sufficiently induce optical interference in incident light by adjusting an average thickness of the wavelength conversion layer to be within the range.

The colored substrate according to the present invention may further include a topcoat formed on the wavelength conversion layer. The topcoat may be formed on the wavelength conversion layer to improve reliability, by improving, for example, scratch resistance, durability, or corrosion resistance of the surface of the colored substrate.

For example, according to the present invention, saline water at 5 wt% and 35°C was uniformly sprayed on the colored substrate by using a salt spray tester (SST) and then was left at 35°C for 72 hours. The surface was evaluated with the naked eye at 24-hour intervals. As a result, it was seen that the substrate was prevented from corroding and the surface was not changed even when the substrate was left for 72 hours after the saline water was sprayed. This means that the topcoat formed on the wavelength conversion layer enhances the corrosion resistance of the colored substrate and thus improves resistance to saline water corrosion.

Also, for another example, according to the present invention, a scratch was generated on a surface of each of a colored substrate in which the topcoat was formed on the wavelength conversion layer and a colored substrate in which the topcoat was not formed. Then, the average depth D of the generated scratch and the exposure of the magnesium base, which was a mother base, due to the generated scratch were checked by using a ball-on-plate-type tribometer. As a result, it was confirmed that a scratch of about 1 $\mu$m was generated and the magnesium base was exposed on the colored substrate not including the topcoat formed on the wavelength conversion layer even under a low load of 5 N, while the mother base was not exposed on the colored substrate including the topcoat formed on the wavelength conversion layer even under high loads of 50 N and 70 N. This indicates that the topcoat formed on the wavelength conversion layer can buffer against an external force applied from the outside, preventing abrasion under high loads of 50 N and 70 N.

From these results, it can be seen that, by sequentially stacking a film including a metal oxide and a wavelength conversion layer on a magnesium base, the colored substrate according to the present invention may uniformly realize a color and may enhance reliability characteristics such as corrosion resistance, durability, and moisture resistance of the colored substrate when a topcoat is formed on the wavelength conversion layer.

At this time, the topcoat is not particularly limited as long as it can coat a surface composed of a metal, a metal oxide, or a metal hydroxide. As one example, the topcoat may be a transparent thin film formed by depositing one or more kinds of metal oxides selected from the group consisting of silicon oxide ($SiO_2$), titanium oxide ($TiO_2$), and aluminum oxide ($Al_2O_3$). In some cases, the topcoat may be coated with a matte/glossy clear coating agent, a clear ceramic coating agent, or a glass coating agent, which is capable of coating a metal.

Also, the topcoat may have an average thickness ranging from 1 $\mu$m to 10 $\mu$m.

Also, according to an embodiment of the present invention, there is provided a substrate coloring method including forming a film on a magnesium base and forming a wavelength conversion layer on the film, wherein the film contains a metal oxide.

The substrate coloring method according to the present invention includes sequentially stacking a film and a wavelength conversion layer on a magnesium base. Thus, it is possible to induce optical interference in incident light by the stacked film and wavelength conversion layer and thus to color a surface thereof.

Here, the formation of a film and the formation of a wavelength conversion layer are not particularly limited as long as they are commonly used to form a thin film in the art. As an example, the formation of a film and the formation of a wavelength conversion layer may be formed by deposition methods such as chemical vapor deposition (CVD), physical vapor deposition (PVD), and atomic layer deposition (ALD). Specifically, the film and the wavelength conversion layer according to the present invention may be performed using plasma enhanced chemical vapor deposition (PECVD) or atmospheric pressure plasma, which is a type of chemical vapor deposition (CVD). The deposition has an advantage in that a film can be uniformly formed on a magnesium base.

In this case, a temperature at which the plasma enhanced chemical vapor deposition is performed may be a temperature at which the film can be uniformly formed, and may be within a range of, specifically, 100°C to 500°C, and more specifically, 200°C to 500°C or 200°C to 400°C.

Also, the plasma enhanced chemical vapor deposition may be performed at a rate within a range of 0.5 nm/min to 1500 nm/min, and specifically 0.5 nm/min to 10 nm/min; 10 nm/min to 100 nm/min; 50 nm/min to 150 nm/min; 100 nm/min to 500 nm/min; 500 nm/min to 1000 nm/min; 750 nm/min to 1000 nm/min; or 900 nm/min to 1500 nm/min. According to the present invention, by adjusting the temperature and the deposition rate of the plasma enhanced chemical vapor deposition to the above range, it is possible to optimize the density of the film deposited on the magnesium base to realize a color on the surface without degrading a unique texture and gloss of the magnesium base.

The substrate coloring method according to the present invention may further include one or more of pre-treating the surface of the magnesium base before the formation of the film; and forming a topcoat on the wavelength conversion layer after the formation of the wavelength conversion layer.

The pretreatment includes washing the surface with an alkaline cleaning liquid to remove residual contaminants or perform polishing before the formation of the film on the magnesium base. In this case, the alkaline cleaning liquid is not particularly limited as long as it is commonly used in the art to clean a surface of a metal, a metal oxide, or a metal hydroxide. Also, the polishing may be performed through buffering, polishing, blasting, or electrolytic polishing, but is not limited thereto. In this step, it is possible not only to remove contaminants or scales present on the surface of the magnesium base but also to enhance adhesion between the magnesium base and the film formed on the magnesium base via surface energy and/or a surface state of the surface, particularly, through a change in microstructure of the surface.

The formation of a topcoat includes forming the topcoat on the wavelength conversion layer to enhance reliability characteristics such as scratch resistance, durability, corrosion resistance, and the like of the colored substrate. Here, the topcoat is not particularly limited as long as it can coat a surface composed of a metal, a metal oxide, or a metal hydroxide. As one example, the topcoat may be a transparent thin film formed by depositing, on the wavelength conversion layer, one or more kinds of metal oxides selected from the group consisting of silicon oxide ($SiO_2$), titanium oxide ($TiO_2$), and aluminum oxide ($Al_2O_3$). In some cases, the topcoat may be coated with a matte/glossy clear coating agent, a clear ceramic coating agent, or a glass coating agent, which is capable of coating a metal. Also, the formation of a topcoat may be performed by a vacuum deposition method such as thermal CVD, plasma CVD, evaporation, sputtering, or ion plating in which a metal oxide such as a silicon oxide ($SiO_2$), a titanium oxide ($TiO_2$), or an aluminum oxide ($Al_2O_3$) may be deposited; by plasma spraying; by electroplating; or by electroless plating. In some cases, the step may be performed using a solution coating method such as dip coating, spin coating, printing, spraying or the like, but is not limited thereto.

[MODE OF THE INVENTION]

Hereinafter, the present invention will be described in detail by embodiments and experimental examples.

However, the following embodiments and experimental examples are merely illustrative of the present invention, and the present invention is not limited to the following embodiments and experimental examples.

Embodiment 1

A magnesium base having 6 cm in width × 6 cm in length × 0.4 T was immersed and degreased in an alkaline cleaning liquid, and a degreased specimen was fastened to a dry evaporator. Subsequently, atomic layer deposition (ALD) was performed at a temperature of 300°C to form a film (average thickness: 20±2 nm) containing aluminum oxide ($Al_2O_3$) on the magnesium base. Subsequently, a wavelength conversion layer (average thickness: 10±2 nm) containing aluminum (Al) was formed by RF/DC sputtering to obtain a colored substrate.

Embodiments 2 to 4

A magnesium base having 6 cm in width × 6 cm in length × 0.4 T was immersed and degreased in an alkaline cleaning liquid, and a degreased specimen was fastened to a dry evaporator. Subsequently, a film was formed by performing plasma enhanced chemical vapor deposition (PECVD) at a temperature of 300°C, and a colored substrate on which a wavelength conversion layer was formed was obtained through E-beam. In this case, the composition and average thickness of the film and the wavelength conversion layer are shown in Table 1 below.

[Table 1]

|  | Film | | Wavelength conversion layer | |
|---|---|---|---|---|
|  | Component | Average thickness | Component | Average thickness |
| Embodiment 2 | Silicon oxide ($SiO_2$) | 350±10 nm | Aluminum (Al) | 10±2 nm |
| Embodiment 3 | Silicon oxide ($SiO_2$) | 500±10 nm | Aluminum (Al) | 10±2 nm |
| Embodiment 4 | Silicon oxide ($SiO_2$) | 200±10 nm | Aluminum (Al) | 7±1 nm |

Embodiments 5 to 8

Each colored substrate obtained in Embodiments 1 to 4 was fastened to a dry evaporator, and a colored specimen in which a transparent topcoat containing a silicon oxide ($SiO_2$) was formed on the wavelength conversion layer was manufactured using plasma enhanced chemical vapor deposition (PECVD) at a temperature of 300°C. In this case, the transparent topcoat had an average thickness of 5±0.1 μm.

Comparative Examples 1 to 6

A magnesium base having 6 cm in width × 6 cm in length × 0.4 T was immersed and degreased in an alkaline cleaning liquid, and a degreased specimen was fastened to a dry evaporator. Subsequently, as shown in Table 2 below, a film was deposited on a magnesium base by RF/DC sputtering at a temperature of 300°C to obtain a substrate having only the film formed thereon.

[Table 2]

|  | Component | Average thickness |
|---|---|---|
| Comparative Example 1 | Aluminum oxide ($Al_2O_3$) | $10\pm5$ nm |
| Comparative Example 2 | Aluminum oxide ($Al_2O_3$) | $300\pm5$ nm |
| Comparative Example 3 | Aluminum oxide ($Al_2O_3$) | $5\pm0.1$ $\mu$m |
| Comparative Example 4 | Silicon oxide ($SiO_2$) | $10\pm5$ nm |
| Comparative Example 5 | Silicon oxide ($SiO_2$) | $300\pm5$ nm |
| Comparative Example 6 | Silicon oxide ($SiO_2$) | $5\pm0.1$ $\mu$m |

Comparative Example 7

A titanium base having 6 cm in width $\times$ 6 cm in length $\times$ 0.4 T was immersed and degreased in an alkaline cleaning liquid, and a degreased specimen was fastened to a dry evaporator. Subsequently, a film containing a silicon oxide ($SiO_2$) was deposited on the titanium base by RF/DC sputtering at a temperature of 300°C to obtain a colored titanium substrate.

Experimental Example 1

The following experiment was conducted to evaluate a change in abrasion resistance of the magnesium base itself caused by the film formed on the magnesium base.

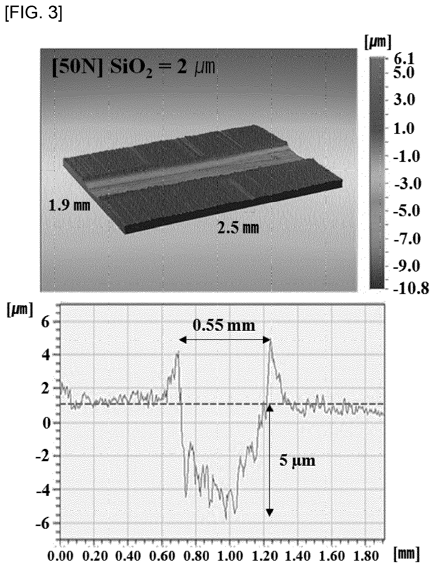

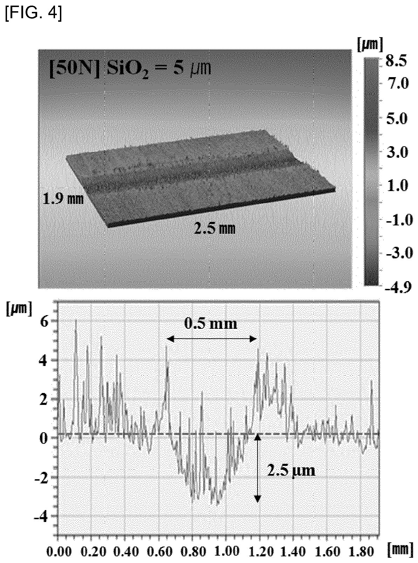

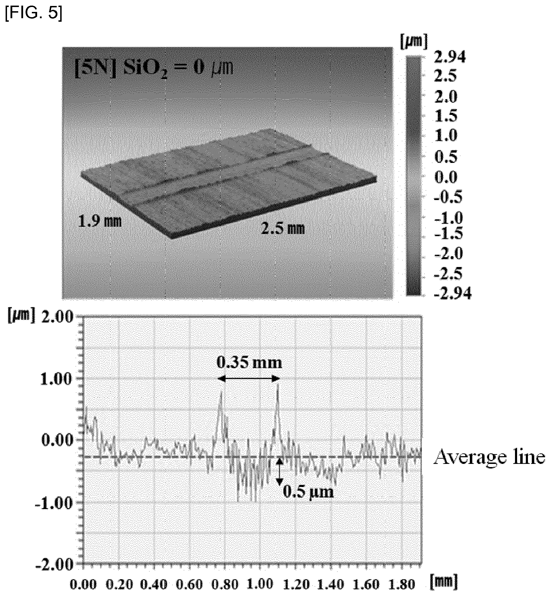

A magnesium base which was not surface-treated and did not contain a film; and a magnesium base on which a film having an average thickness of $2\pm0.1$ $\mu$m and $5\pm0.2$ $\mu$m was formed on a surface thereof were prepared. Subsequently, a scratch was generated on a surface of the base. Then, the average width and the average depth D of the generated scratch and the exposure of the magnesium base, which was a mother base, caused by the generated scratch were checked by using a ball-on-plate-type tribometer. At this point, the scratch was performed at a rate of 3 cm/s, under a load of 5 N or 50 N, and at a temperature of $20\pm2$°C by means of a ball (diameter: 6 mm) on the surface of the magnesium substrate. In principle, the same spot was scratched once. The series of processes were repeatedly performed on five magnesium substrates to obtain an average value. Abrasion resistance HS of the surface-treated substrate was derived from the average value by using the following Equation 2. The result is shown in the following Table 3 and FIGS. 3 to 5.

$$[Equation\ 2]$$

$$HS = 8\cdot L/\pi\cdot W^2$$

where W is an average width (unit: $\mu$m) of a scratch generated on a surface of the film when the surface was scratched with a ball having an average diameter of 6 mm at a rate of 3 cm/s, and L is a load of the ball when the scratch was generated.

[Table 3]

| Average thickness of film [$\mu$m] | Load | Average depth [D, $\mu$m] | Average width [W, $\mu$m] | HS [GPa] |
|---|---|---|---|---|
| 0 | 5N | $0.5\pm0.05$ | $350\pm15$ | 0.1040 |
| $2\pm0.1$ | 5N | 0 | 0 | - |
| $5\pm0.2$ | 5N | 0 | 0 | - |
| $2\pm0.1$ | 50N | $5.0\pm0.05$ | $550\pm20$ | 0.4211 |
| $5\pm0.2$ | 50N | $2.5\pm0.1$ | $500\pm20$ | 0.5096 |

As shown in Table 3 and FIGS. 3 to 5, it can be seen that a magnesium base on which a film was formed had enhanced abrasion resistance.

Specifically, when a scratch was intended to be generated under a load of 5 N, it was found that a substrate on which a film containing a metal oxide was formed to an average thickness of 1 nm to 6 $\mu$m was not scratched. Particularly, the substrate was found to have a scratch when the film was pressed under a load of 50 N, but the depth thereof was found to be insignificant. Also, when the load of the ball was 50 N, the substrate was found to have abrasion resistance (HS) in Equation 2 ranging from 0.3 GPa to 0.6 GPa. On the other hand, when a scratching force was generated under a load of 5 N on the magnesium substrate on which no film was formed, a significant scratch having an average width of 0.5±0.05 $\mu$m and an average thickness of 350±15 $\mu$m was found to have been generated.

From this result, it can be seen that a film containing a metal oxide was formed on the magnesium base to an average thickness of 1 nm to 6 $\mu$m, and thus it is possible to buffer against abrasion generated on the surface of the magnesium base and also to protect a magnesium material, which is a mother material.

Experimental Example 2

The following experiment was performed to evaluate color and its uniformity on the colored substrate according to the present invention.

The colors of the colored substrates obtained in Embodiments 1 to 3 and Comparative Examples 1 to 6 were evaluated with the naked eye. Also, three arbitrary points A to C present on a surface of each of the substrates obtained in Embodiments 1 to 3 were selected, color coordinates in the CIE color space were measured at the selected points, and then an average color coordinate deviation was obtained from the color coordinates. In this case, the color coordinate deviation $\Delta$E* was derived from Equation 1. The result is shown in Table 4 below.

[Table 4]

| | Three Points | L* | A* | b* | $\Delta$L* | $\Delta$a* | $\Delta$b* | $\Delta$E* |
|---|---|---|---|---|---|---|---|---|
| | A | 63.15 | -2.52 | -0.11 | - | - | - | - |
| Embodiment 1 | B | 62.97 | -2.55 | 0.08 | 0.18 | 0.03 | 0.03 | 0.27 |
| | C | 63.29 | -2.54 | 0.01 | 0.15 | 0.02 | 0.12 | 0.19 |
| | A | 62.33 | -24.02 | -12.39 | - | - | - | - |
| Embodiment 2 | B | 62.43 | -23.74 | -12.85 | 0.10 | 0.28 | 0.46 | 0.55 |
| | C | 62.54 | -23.89 | -12.85 | 0.21 | 0.13 | 0.46 | 0.52 |
| | A | 59.55 | 21.13 | -18.16 | - | - | - | - |
| Embodiment 3 | B | 59.50 | 21.24 | -18.41 | 0.06 | 0.12 | 0.25 | 0.28 |
| | C | 59.46 | 21.320 | -18.45 | 0.10 | 0.19 | 0.29 | 0.37 |

First, the colors of the substrates manufactured in Embodiments 1 to 3 were evaluated with the naked eye. In Embodiments 1 to 3 in which a wavelength conversion layer was formed on a film, the substrates were colored to be gray, cyan, and red, respectively. In Comparative Examples 1 to 6 in which no wavelength conversion layer was formed, the surfaces were not colored. Also, the substrate of Comparative Example 7 in which a titanium base instead of a magnesium base was included had a different coloring mechanism based on its base component. Thus, the substrate was found to be colored yellow because the substrate included no wavelength conversion layer.

Further, referring to Table 3, it can be seen that the substrates manufactured in Embodiments 1 to 3 had uniform colors. More specifically, in the substrates manufactured in Embodiments 1 to 3, color coordinate deviations between three arbitrary points present on the specimens were .05<$\Delta$L*<0.25, 0.01 <$\Delta$a*<0.3, and 0.2<$\Delta$b*<0.5. Also, the colored substrates exhibited a color coordinate deviation of 0.15<$\Delta$E*≤0.55, and a deviation between realized colors was small.

From the result, it can be seen that, by forming a structure in which a film containing a metal oxide and a wavelength conversion layer are sequentially stacked on a magnesium base, which is not colored with just the film containing a metal oxide, the colored substrate according to the present invention may uniformly realize a color on a surface thereof.

Experimental Example 3

The following experiment was performed to evaluate reliability characteristics such as corrosion resistance, durability, moisture resistance, and abrasion resistance of the colored substrate according to the present invention upon formation of a topcoat.

A. Evaluation of corrosion resistance against saline water

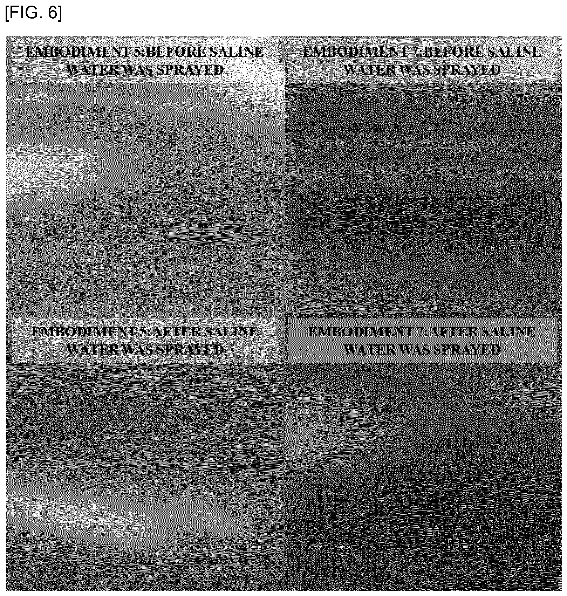

5 wt% saline water was uniformly sprayed on each colored substrate obtained in Embodiments 5 and 7 by using a salt spray tester (SST) and then was left at 35°C for 72 hours. The surface was evaluated with the naked eye at 24-hour intervals. The result is shown in FIG. 6.

Referring to FIG. 6, it can be seen that the substrates of Embodiments 5 to 7 in which a topcoat was formed on a wavelength conversion layer were prevented from corroding and the surfaces were not changed even when the substrates were left for 72 hours after the saline water was sprayed. This means that the topcoat formed on the wavelength conversion layer enhances the corrosion resistance of the colored substrate, thus improving resistance to saline water corrosion.

B. Evaluation of durability

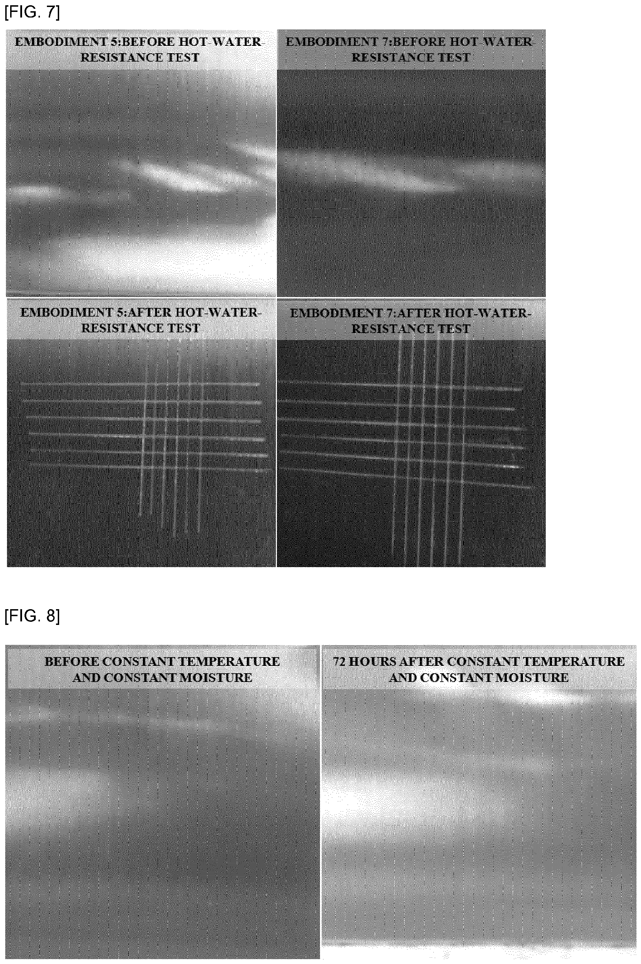

The colored substrates obtained in Embodiments 5 and 7 were immersed in a hot-water-resistance testing apparatus with distilled water having a temperature of 95°C for 30 minutes, and whether the color changed was determined with the naked eye. Then, the degree to which the wavelength conversion layer and the topcoat were lifted off from the surface of the magnesium base was measured through a cross-cut tape test. Here, in the cross-cut tape test, the surface of the colored substrate was cut with a knife so that six horizontal lines and six vertical lines intersected each other. Subsequently, a tape was firmly attached to intersections of the horizontal lines and the vertical lines, and a lifted area of a thin film with respect to the entire area of the specimen was determined. The result is shown in FIG. 7.

Referring to FIG. 7, in the substrates of Embodiments 5 and 7, lifting and surface discoloration of the wavelength conversion layer and the topcoat formed on the magnesium base were prevented even after the immersion in the hot distilled water, and thus the area where the wavelength conversion layer and the top coat were lifted off or discolored was found to be 1% or less with respect to the entire area. This indicates that the wavelength conversion layer and the topcoat were uniformly formed on the magnesium substrate with high adhesion.

C. Evaluation of moisture resistance

The colored substrate obtained in Embodiment 5 was placed in a constant temperature and humidity testing apparatus at conditions 50°C and 95% and was neglected for 72 hours. Then, the state of the surface was evaluated with the naked eye. The result is shown in FIG. 8.

Referring to FIG. 8, a change in surface such as discoloration did not occur in the colored substrate in Embodiment 5 under high temperature and high humidity conditions. The result shows that since the wavelength conversion layer and the topcoat had high adhesion, the colored substrate had enhanced moisture resistance, and thus surface deformation did not occur even under high temperature and high humidity conditions.

D. Evaluation of abrasion resistance

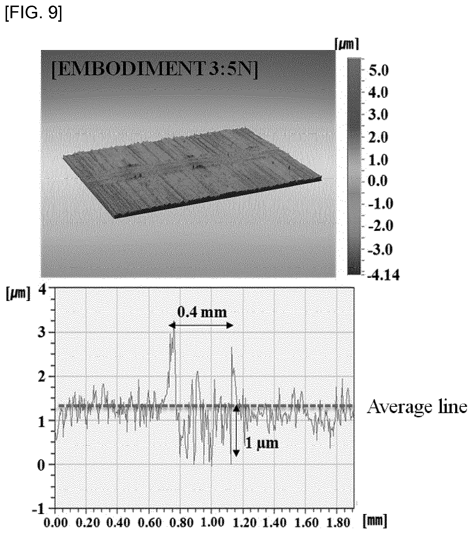

A scratch was generated on each surface of the colored substrates obtained in Embodiments 3 and 8, and the average depth D of the generated scratch and the exposure of the magnesium base, which is a mother base, caused by the generated scratch were checked by using a ball-on-plate-type tribometer. Here, the scratch was performed at a rate of 3 cm/s, under a load of 5 N, 50 N, or 70 N, and at a temperature of $20\pm2$°C by means of a ball (diameter: 6 mm) on the surface of the magnesium substrate. In principle, the same spot was scratched once. The series of processes were repeatedly performed on three magnesium substrates three times to obtain an average value. The result is shown in FIGS. 9 to 11.

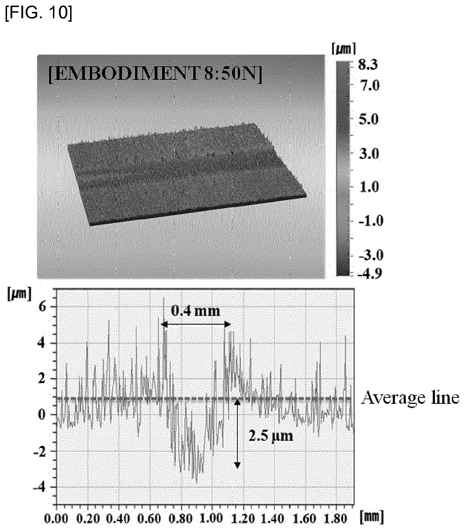

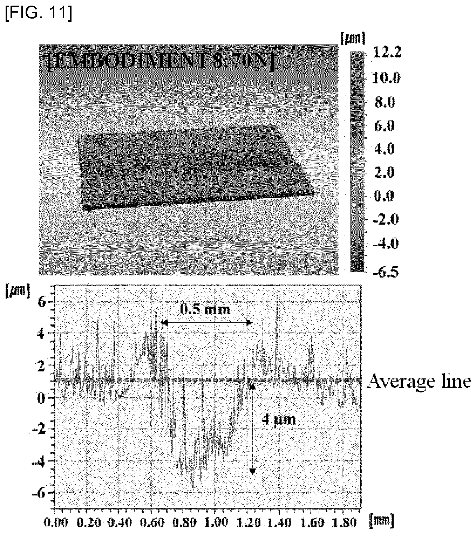

First, it was confirmed that a scratch of about 1 $\mu$m was generated and the magnesium base was exposed on the colored substrate of Embodiment 3 in which no topcoat was included in the wavelength conversion layer even under a low load of 5 N. On the other hand, referring to FIGS. 10 and 11, the mother base was not exposed in the colored substrate of Embodiment 8 in which a topcoat was included in the wavelength conversion layer even under high loads of 50 N and 70 N. This indicates that the top coat formed on the wavelength conversion layer can buffer against an external force applied from the outside to prevent abrasion at high loads of 50 N and 70 N.

From these results, it can be seen that, by sequentially stacking a film including a metal oxide and a wavelength conversion layer on a magnesium base, the colored substrate according to the present invention may uniformly realize a color and may enhance reliability characteristics such as corrosion resistance, durability, and moisture resistance of the colored substrate when a top coat is formed on the wavelength conversion layer.

[INDUSTRIAL APPLICABILITY]

The colored substrate according to the present invention has a structure in which a film containing a metal oxide and a wavelength conversion layer are sequentially stacked on a magnesium base, and can thus uniformly display various colors on a surface thereof through the control of the average thickness of the film while maintaining a unique metal texture and metal gloss. Therefore, the colored substrate can be usefully utilized in the fields of building exteriors, automobile interiors, and particularly electrical and electronic component materials such as mobile product frames.

**Claims**

1. A colored substrate comprising:

   a magnesium base;
   a film provided on the magnesium base, the film containing a metal oxide; and
   a wavelength conversion layer provided on the film.

2. The colored substrate of claim 1, wherein the metal oxide is one selected from a group consisting of a silicon oxide, a titanium oxide, and an aluminum oxide.

3. The colored substrate of claim 1, wherein the wavelength conversion layer contains one or more kinds of metals or ions from a group consisting of aluminum (Al), chromium (Cr), titanium (Ti), gold (Au), molybdenum (Mo), silver (Ag), manganese (Mn), zirconium (Zr), palladium (Pd), platinum (Pt), cobalt (Co), cadmium (Cd), nickel (Ni), and copper (Cu).

4. The colored substrate of claim 1, wherein the wavelength conversion layer has an average thickness of 5 nm to 200 nm.

5. The colored substrate of claim 1, wherein the film has an average thickness of 1 nm to 6 $\mu$m.

6. The colored substrate of claim 1, wherein with respect to three arbitrary points included in an arbitrary area (having a width of 1 cm and a length of 1 cm) present on the wavelength conversion layer, average color coordinate deviations between the points ($\Delta L^*$, $\Delta a^*$, and $\Delta b^*$) satisfy one or more of conditions $\Delta L^*<0.5$, $\Delta a^*<0.6$, and $\Delta b^*<0.6$.

7. The colored substrate of claim 1, further comprising a topcoat formed on the wavelength conversion layer.

8. The colored substrate of claim 7, wherein the topcoat contains one kind of metal oxide selected from a group consisting of a silicon oxide, a titanium oxide, and an aluminum oxide.

9. The colored substrate of claim 7, wherein when abrasion resistance of a surface of the magnesium surface on which the film is formed is evaluated, the colored substrate satisfies Equation 1 below:

[Equation 1]

$$3 \leq 400/\pi \cdot W^2 \leq 20$$

where W is an average width of a scratch generated on a surface of the film when the surface is scratched with a ball having an average diameter of 6 mm under a load of 50 N and at a rate of 3 cm/s, and has a unit of GPa.

10. A substrate coloring method comprising:

    forming a film on a magnesium base; and
    forming a wavelength conversion layer on the film, wherein the film contains a metal oxide.

11. The substrate coloring method of claim 10, wherein the formation of a film and the formation of a wavelength conversion layer are performed by chemical vapor deposition (CVD), physical vapor deposition (PVD), or atomic layer deposition (ALD).

12. The substrate coloring method of claim 11, wherein the chemical vapor deposition includes plasma enhanced chemical vapor deposition (PECVD).

13. The substrate coloring method of claim 12, wherein the plasma enhanced chemical vapor deposition is performed at a temperature of 100°C to 500°C.

14. The substrate coloring method of claim 12, wherein the plasma enhanced chemical vapor deposition is performed at a rate of 0.5 nm/min to 1500 nm/min.

15. The substrate coloring method of claim 10, further comprising one or more of:

pre-treating the surface of the magnesium base before the formation of the film; and
forming a topcoat on the wavelength conversion layer after the formation of the wavelength conversion layer.

[FIG. 1]

L = 100 (WHITE)

BRIGHTNESS

-a (GREEN)          +b (YELLOW)

-b (BLUE)          +a (MAGENTA)

L = 0 (BLACK)

[FIG. 2]

10
20
30

[FIG. 3]

[FIG. 4]

[FIG. 5]

[FIG. 6]

[FIG. 7]

[FIG. 8]

[FIG. 9]

[FIG. 10]

[FIG. 11]

| | INTERNATIONAL SEARCH REPORT | International application No. |
|---|---|---|
| | | **PCT/KR2015/014157** |

**A. CLASSIFICATION OF SUBJECT MATTER**

*C23C 28/00(2006.01)i, C23C 16/06(2006.01)i, C23C 16/22(2006.01)i, C23C 16/455(2006.01)i, C23C 16/40(2006.01)i, C23C 14/08(2006.01)i, C23C 14/14(2006.01)i, C23C 14/16(2006.01)i*

According to International Patent Classification (IPC) or to both national classification and IPC

**B. FIELDS SEARCHED**

Minimum documentation searched (classification system followed by classification symbols)

C23C 28/00; C23C 22/57; C23C 30/00; C23C 22/46; C23C 14/34; C23C 20/06; C23C 14/14; C23C 16/06; C23C 16/22; C23C 16/455; C23C 16/40; C23C 14/08; C23C 14/16

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: color formation, substrate, magnesium material, metal oxide, wavelength-converting layer, thin film

**C. DOCUMENTS CONSIDERED TO BE RELEVANT**

| Category* | Citation of document, with indication, where appropriate, of the relevant passages | Relevant to claim No. |
|---|---|---|
| Y | KR 20-0402239 Y1 (TAE YANG C&L CO., LTD.) 29 November 2005<br>See abstract, claims 1, 2 and figure 2. | 1-15 |
| Y | JP 2010-265522 A (KANSAI PAINT CO., LTD. et al.) 25 November 2010<br>See abstract, paragraphs [0010]-[0023], claim 1 and figure 1. | 1-15 |
| A | WO 2015-099503 A1 (POSCO) 02 July 2015<br>See abstract and claims 1-9. | 1-15 |
| A | KR 10-2011-0016750 A (RESEARCH INSTITUTE OF INDUSTRIAL SCIENCE & TECHNOLOGY et al.) 18 February 2011<br>See abstract, paragraphs [0028]-[0050], claim 1 and figure 2. | 1-15 |
| A | KR 10-2011-0137107 A (COTEC CORP.) 22 December 2011<br>See abstract, claims 1-6 and figure 3. | 1-15 |

| ☐ Further documents are listed in the continuation of Box C. | ☒ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 JULY 2016 (21.07.2016) | **25 JULY 2016 (25.07.2016)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea | |
| Facsimile No. 82-42-472-7140 | Telephone No. |

Form PCT/ISA/210 (second sheet) (January 2015)

INTERNATIONAL SEARCH REPORT
Information on patent family members

International application No.

**PCT/KR2015/014157**

| Patent document cited in search report | Publication date | Patent family member | Publication date |
|---|---|---|---|
| KR 20-0402239 Y1 | 29/11/2005 | NONE | |
| JP 2010-265522 A | 25/11/2010 | NONE | |
| WO 2015-099503 A1 | 02/07/2015 | KR 10-1543924 B1 | 12/08/2015 |
| | | KR 10-1543925 B1 | 12/08/2015 |
| | | KR 10-1543926 B1 | 12/08/2015 |
| | | KR 10-1584413 B1 | 11/01/2016 |
| | | KR 10-1615457 B1 | 25/04/2016 |
| | | WO 2015-099496 A1 | 02/07/2015 |
| | | WO 2015-099498 A1 | 02/07/2015 |
| | | WO 2015-099501 A1 | 02/07/2015 |
| | | WO 2015-099505 A1 | 02/07/2015 |
| KR 10-2011-0016750 A | 18/02/2011 | KR 10-1117800 B1 | 09/03/2012 |
| KR 10-2011-0137107 A | 22/12/2011 | NONE | |

Form PCT/ISA/210 (patent family annex) (January 2015)

23

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20110016750

- US 20110303545 A